# EUROPEAN PATENT APPLICATION

(11) **EP 1 429 592 A1**
(43) Date of publication of application: **16.06.2004**
(21) Application number: 02354191.5
(22) Date of filing: 09.12.2002
(51) Int. Cl.: H05K 9/00, G06F 1/18

(54) **Electromagnetic shield**

(71) Applicant: Hewlett-Packard Company (a Delaware corporation), Palo Alto, CA 94304 (US)
(72) Inventor: Rieuvernet, Pierre, 38330 Montbonnot st Martin (FR); Cohen, Xavier, 38000 Grenoble (FR); Dreux, Jean-Francois, 38400 Saint-Martin D'Heres (FR)
(74) Representative: Lloyd, Richard Graham

(57) **Abstract**

An electromagnetic absorber (10) for a computer includes an array of conduits (12) therein to allow airflow but which have internal walls which are conductive so as to absorb electromagnetic radiation. The absorber member (10) is formed in one embodiment from a foamed material which may either be of an inherently non-conductive material such as polyurethane which is treated so as to be conductive or from a foamed metal or metal alloy. Alternatively, the member could be formed from a non-conductive material such as a plastics material, rubber or cork, which is treated so as to be conductive. The member (10) can allow for passages of greater diameter than prior art shields for cooling air flow without compromising the shielding effect and without adding significant cost, noise of weight penalties. In the preferred embodiment, there is provided better shielding and noise absorption.

## Description

### Field of the Invention:

The present invention relates to an electromagnetic shield, to a casing and to a computer incorporating an electromagnetic shield.

### Background of the Invention:

It is well known that microprocessors and other electronic components emit electromagnetic radiation which needs to be shielded from the environment outside the computer. This is typically achieved by enclosing the microprocessor within an electromagnetic shield, usually provided by the casing of the computer itself. However, in order to provide a flow of air to the microprocessor chip and other components for cooling purposes, it is necessary to provide apertures in the computer casing. However, these apertures provide an escape path for electromagnetic radiation and therefore have maximum useful dimensions to reduce such escape. It is generally preferred that the apertures are not greater than around 10% of the wavelength of the electromagnetic radiation produced by the microprocessor or other electronic component.

As the processing speeds of microprocessors and other electronic components increase, the wavelength of electromagnetic radiation produced during their operation is shortened, thereby requiring air circulation apertures of smaller dimensions. However, smaller apertures provide less cooling and in conditions where the components produce more heating. This therefore creates a problem.

It is, of course, possible to provide cooling fans within the computer or other device. However, the cooling fans are an additional cost, require power to be operated and create noise.

One possible solution would be to form the apertures as waveguides of dimensions which absorb electromagnetic radiation passing therethrough. However, to be practicable, such waveguides would typically need to be formed within a relatively thick wall, such as a thick metal plate, in the casing of the computer or other device. Although such a solution might allow larger apertures to provide greater flow of cooling air, the added weight is disadvantageous.

### Summary of the Present Invention:

The present invention seeks to provide an improved electromagnetic absorber and an improved computer, such as a personal computer.

According to an aspect of the present invention, there is provided an electromagnetic absorber for absorbing electromagnetic radiation including a member of foamed material having a plurality of air conduits formed therein, which conduits have walls capable of absorbing electromagnetic radiation.

The absorber structure provides waveguide-like passages which can have a larger internal diameter than simple holes in a computer casing but which can nevertheless absorb smaller wavelength electromagnetic radiation and without incurring a significant added weight penalty. Thus, this structure can provide for improved cooling without the disadvantages mentioned above.

In one embodiment, the foamed member is formed from polyurethane. Advantageously, the member is formed from a polyurethane to which small particles of carbon are added and then foamed to produce the final member. Alternatively, the foamed material could be painted, for example by dipping the foamed material into conductive paint. The conductive paint could, for example, be provided with metallic particles such as silver particles.

In another embodiment, the internal walls of the passages are provided with a conductive coating, such as by painting or by insertion of a conductive tube held against the internal walls of the passages.

Advantageously, the foamed member is of an open cell type.

In another embodiment, the foamed member is formed from a foamed metal or metal alloy of the type disclosed, for example, in WO-01/62416.

Preferably, in any of the alternatives disclosed herein, the material of the absorber is acoustically absorbing.

Advantageously, the absorber structure is resilient or provided with a resilient bushing to facilitate mounting the member to, for example, a computer casing.

According to another aspect of the present invention, there is provided an electromagnetic absorber for absorbing electromagnetic radiation including a member of non-conductive material having a plurality of air conduits formed therein, which conduits are provided with internal walls capable of absorbing electromagnetic radiation.

According to another aspect of the present invention, there is provided an electromagnetic absorber for absorbing electromagnetic radiation from a computer including a member of open cell foamed material having a plurality of air conduits formed therein, which conduits have walls of a conductive material capable of absorbing electromagnetic radiation.

According to another aspect of the present invention, there is provided a casing including within at least part thereof an electromagnetic absorber including a member of foamed material having a plurality of air conduits formed therein, which conduits have walls capable of absorbing electromagnetic radiation.

The casing can be provided with fixtures for fixing the electromagnetic absorber structure to an opening within the case. The fixings could, advantageously, be releasable fixings.

In another embodiment, the electromagnetic absorber is formed integrally with the casing and may, for example, be formed of the same material as the casing. In this case, the entirety of the casing could be formed as an electromagnetic absorber having the structure taught herein.

The casing is preferably that of a computer, advantageously a personal computer.

### Description of the Drawings:

Embodiments of the present invention are described below, by way of example only, with reference to the accompanying drawings, in which:
Figure 1 is a perspective view of an embodiment of electromagnetic absorber and of fixings therefor; and
Figure 2 shows a portion of an embodiment of computer casing in which the electromagnetic absorber of Figure 1 is fitted.

### Description of the Preferred Embodiments:

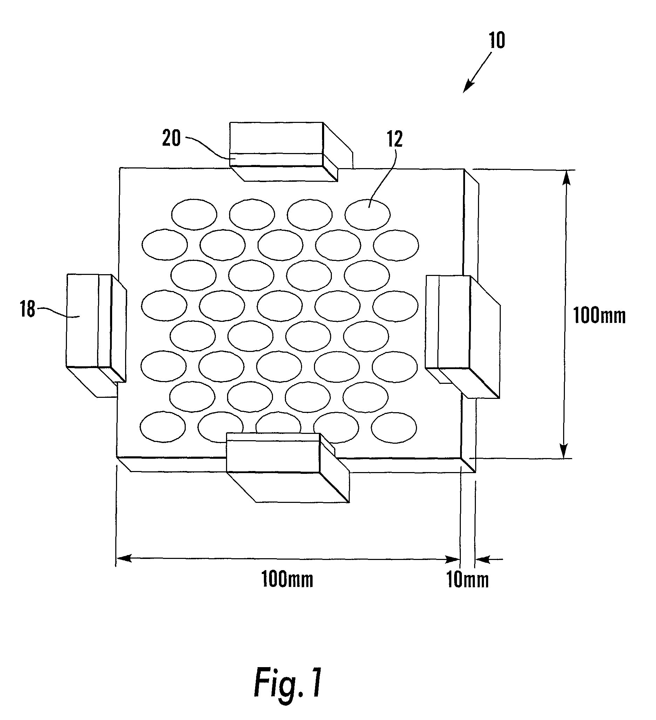

Referring to Figure 1, the embodiment of electromagnetic absorber 10 shown has a rectangular cuboid shape with, in this example, a thickness of around 10 mm, a height of around 100 mm and a width of around 100 mm. These dimensions are chosen simply for this example and will be dependant upon the particular application of the absorber 10, for example in a computer or other device.

The absorber 10 is provided with an array of bores or conduits (referred to herein as passages) 12 which pass through the absorber 10. The passages 10 preferably are substantially circular in axial cross-section and have, in this example, a diameter of between 10-15 mm.

It will be appreciated by the skilled person that the thickness of the absorber 10 and the internal diameter of the passages 12 would be chosen on the basis of the wavelength of the electromagnetic radiation to be shielded or absorbed by the absorber 10.

In this embodiment, the absorber 10 is formed from a foamed material which is either inherently conductive or which is treated so as to be conductive, as described below. In the preferred embodiment, the absorber 10 is formed of a foamed polyurethane material. The polyurethane material could be pre-impregnated with conductive particles, such as particles of carbon, prior to being expanded into a foam, thereby making it inherently conductive. Alternatively, the polyurethane material could be formed into the structure shown in Figure 1 and then treated so as to become conductive. It is envisaged that one form of treatment would be to provide a metallic coating on the foamed structure by painting with a conductive paint, for example a paint incorporating metallic particles, such as silver particles.

In an alternative embodiment, only the passages 12 are coated so as to be conductive. This can be by painting or by the provision of a separate conductive tubes which are dimensioned so as to fit within the passages 12 and to remain therein by a friction fit or by use of a suitable adhesive for welding. In this embodiment, the conductive tubes must be electrically in contact with the chassis, which means practically that at least one flat side of the absorber is made conductive or some other electrical contact provided.

Of these alternatives, it is preferable to coat the entirety of the polyurethane structure with a conductive material. This provides the additional advantage of giving the entirety of the structure 10 a non-flammable coating.

In the preferred embodiment, the material is acoustically absorbing.

It is also envisaged that the foamed structure can formed from a foamed metal or metal alloy of the type disclosed, for example, in WO-01/62416. Such materials are available from Cymat Corporation of 6320-2 Danville Road, Mississauga, Ontario L5T 2L7, Canada.

In an alternative embodiment, the absorber 10 is formed from a non-conductive material such as a plastics material, rubber or cork, which is treated so that the passages 12 are conductive. The advantage of using non-conductive materials is that they tend to be less dense than solid metals or metal alloys and can therefore provide an electromagnetic absorber having the characteristics described herein but without the weight penalty of a structure formed purely of solid metal or metal alloy. In this embodiment, the conductive tubes must be electrically in contact with the chassis, which means practically that at least one flat side of the absorber is made conductive or some other electrical contact provided.

These alternative embodiments could have the features of the principal embodiments described in connection with Figure 1.

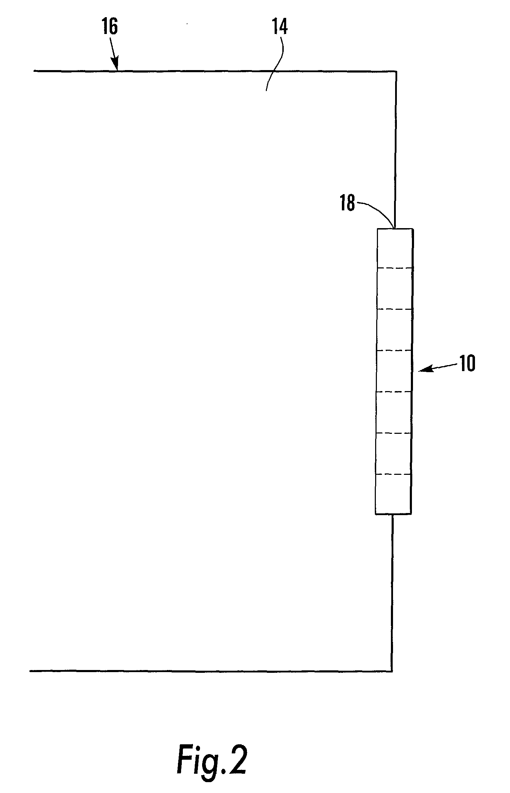

Figure 2 shows the absorber 10 fitted within the casing 14 of a computer 16, which in this example is a personal computer. The absorber 10 is located within an aperture 18 of the casing 14 which has dimensions substantially identical to the height and width dimensions of the absorber 10. Visible in Figure 1 are four fixings 18 provided with resilient (rubber) bushings 20 to retain the absorber 10 in place but which nevertheless allow the absorber to be electrically coupled to the casing and thereby to ground.

The example of fixings 18, 20 shown is only one of a variety of possibilities. Alternative examples are to provide a bushing around the entirety or substantially the entirety of the periphery of the absorber 10 which engages with the walls of the aperture 18 in the computer casing 14. Alternatively, the absorber 10 can be formed such that its peripheral walls are resilient to enable the absorber 10 to be press-fitted into the aperture 18.

In another embodiment, the absorber 10 is formed integrally with the casing 14 and could, for example, be formed of the same material as the casing 14. In another embodiment, the entirety of the casing 14 is formed as an absorber having the characteristics of the absorber 10 of Figures 1 and 2.

In all these alternatives, the conductive part of the absorber 10 is coupled to ground, by a simple electrical and mechanical connection or by a specific electrical connection such as a wire. Examples of coupling methods include gluing with an electrically conductive glue or pattern, rails, a metallic frame clipped to the aperture in the casing and so on.

The described embodiments provide an electromagnetic absorber which can be used with higher frequency and higher power microprocessors and other electronic components without adding significant weight penalty or cost to the device and which can nevertheless provide improved air flow for cooling purposes. They can be relatively cheap to manufacture and assemble and can also be acoustically absorbing to reduce noise levels outside the computer or other device 16.

## Claims

1. An electromagnetic absorber for absorbing electromagnetic radiation including a member (10) of foamed material having a plurality of air conduits (12) formed therein, which conduits have walls capable of absorbing electromagnetic radiation.

2. An electromagnetic absorber according to claim 1, wherein the foamed member is formed from polyurethane.

3. An electromagnetic absorber according to claim 2, wherein the member is formed from polyurethane to which small particles of carbon are added.

4. An electromagnetic absorber for absorbing electromagnetic radiation including a member of non-conductive material having a plurality of air conduits formed therein, which conduits have internal walls capable of absorbing electromagnetic radiation.

5. An electromagnetic absorber according to any preceding claim, wherein the member is painted with a conductive paint.

6. An electromagnetic absorber according to any preceding claim, wherein the internal walls of the passages (12) are provided with a conductive coating.

7. An electromagnetic absorber according to claim 6, wherein the conductive coating is formed from one of painting and insertion of a conductive tube held against the internal walls of the passages (12).

8. An electromagnetic absorber according to claim 1, wherein the foamed member (10) is formed from one of a foamed metal and foamed metal alloy.

9. An electromagnetic absorber according to any preceding claim, wherein the material of the absorber is acoustically absorbing.

10. A casing including within at least a part thereof an electromagnetic absorber according to any preceding claim.

11. A casing according to claim 10, including an opening and fixtures for fixing the electromagnetic absorber structure into the opening.

12. A casing according to claim 10, wherein the electromagnetic absorber is formed integrally with the casing.

13. A casing according to claim 10, 11 or 12, wherein the conduits have a cross-sectional diameter of between 10 and 15 mm.

14. A computer including a casing according to any one of claims 10 to 13.

15. A personal computer including a casing according to any one of claims 10 to 13.

16. Use in an electromagnetic absorber of one of a foamed member having a plurality of air conduits formed therein and a member of non-conductive material having a plurality of air conduits formed therein, which conduits have internal walls capable of absorbing electromagnetic radiation.
